**Europäisches Patentamt**

**European Patent Office**

**Office européen des brevets**

(11) Veröffentlichungsnummer: **0 024 604**
**B1**

(12) # EUROPÄISCHE PATENTSCHRIFT

(45) Veröffentlichungstag der Patentschrift:
28.09.83

(51) Int. Cl.³: **C 23 C 13/02, C 23 C 13/12**

(21) Anmeldenummer: **80104686.3**

(22) Anmeldetag: **08.08.80**

(54) Verfahren und Vorrichtung zum Aufdampfen von elektrisch leitenden Stoffen (Metallen) im Hochvakuum.

(30) Priorität: **22.08.79 DE 2934011**

(43) Veröffentlichungstag der Anmeldung:
**11.03.81 Patentblatt 81/10**

(45) Bekanntmachung des Hinweises auf die Patenterteilung:
**28.09.83 Patentblatt 83/39**

(84) Benannte Vertragsstaaten:
**DE FR GB IT**

(56) Entgegenhaltungen:
**AT-B-209 665**
**CH-A-511 291**
**DD-A-72 658**

(73) Patentinhaber: **de Rudnay, André, Dr., 16 Chemin de Renens Château de Valency, CH-1004 Lausanne (CH)**

(72) Erfinder: **de Rudnay, André, Dr., 16 Chemin de Renens Château de Valency, CH-1004 Lausanne (CH)**

(74) Vertreter: **Seibert, Rudolf, Dipl.-Ing., Tattenbachstrasse 9, D-8000 München 22 (DE)**

BUNDESDRUCKEREI BERLIN

EP 0 024 604 B1

## Verfahren und Vorrichtung zum Aufdampfen von
## elektrisch leitenden Stoffen (Metallen) im Hochvakuum

Die Erfindung bezieht sich auf eine Vorrichtung zum Aufdampfen von leitenden Stoffen, wie Metallen, Metallverbindungen oder dgl. im Hochvakuum auf bewegte oder unbewegte Gegenstände, vorzugsweise Trägerfolien oder -bahnen, und zwar im kontinuierlichen oder diskontinuierlichen Betrieb. Im besonderen ist die Erfindung zur Anwendung in Bandbedampfungsanlagen bestimmt.

Zum Bedampfen von Trägerfolien oder Trägerbahnen aus Papier, Kunststoff oder dgl. sind Bedampfungsanlagen oder andere Vakuumanlagen (Hochvakuumanlagen) bekannt, in welchen große Mengen von Metallen, wie beispielsweise Al, Ag, Au usw. oder metallisch leitende Verbindungen, wie beispielsweise CrNi oder aber auch Halbleiter, wie beispielsweise Si, aufgedampft werden. Das aufzudampfende Material wird dabei in einem oder mehreren widerstandsbeheizten, wannenförmig ausgebildeten, d. h. mit einer Vertiefung versehenen Verdampfer aus einem hochschmelzenden Metall oder einer entsprechenden Verbindung, geschmolzen und das Schmelzgut auf die erforderliche Aufdampftemperatur, die meistens mehrere hundert Grad Celsius oberhalb der Schmelztemperatur liegt, erhitzt.

So bestehen beispielsweise Verdampfer für Al, welches eine Schmelztemperatur von 660°C aufweist, üblicherweise aus einer elektrisch leitenden Sinterkeramik $AlN + BN + TiB_2$. Die Verdampfer werden dabei auf eine Temperatur von 1450° bis 1500°C erwärmt. Verdampfer für Ag mit einer Schmelztemperatur von 961°C und für Au mit einer Schmelztemperatur von 1063°C bestehen meistens aus Wolfram und müssen zum ausreichenden Verdampfen des Schmelzgutes auf etwa 2000°C erhitzt werden.

Die extrem hohen Temperaturen, welche für eine rationelle Aufdampfrate benötigt werden, führen zu einem hohen Verschleiß der Verdampfer selbst. Die Standzeit der üblichen Verdampfer beträgt im allgemeinen 10 bis 20 Stunden. Diese verhältnismäßig niedrige Standzeit könnte an sich vervielfacht werden, falls die angeführten Aufdampftemperaturen um einige hundert Grad Celsius erniedrigt würden. In diesem Fall würde aber die Aufdampfrate des Aufdampfgutes auf einen Bruchteil der praktisch geforderten Aufdampfraten sinken.

Weiter sind Verdampfer in Tiegelform aus Graphit bekanntgeworden, welche auf der Innenseite durch Aufschmelzen von Ti mit einer Schicht von TiC oder durch Bestreichen mit BN mit einer elektrisch nichtleitenden, keramischen Schicht aus diesem Material versehen und als induktionsbeheizte Tiegel zum Aufdampfen von Al verwendet werden. Auch diese Verdampfer haben nur eine verhältnismäßig kurze Standzeit.

Sie haben weiter den Nachteil, daß der mitverdampfende Kohlenstoff in der kondensierten Aluminiumschicht zur Bildung der unerwünschten, übelriechenden und in der Feuchtigkeit sich zersetzenden Verbindung AlC führt. Man versucht deshalb, die induktivbeheizten Verdampfer mit Tiegeln aus einer elektrisch nicht leitenden keramischen Verbindung, beispielsweise aus AlN oder BN für das Aufdampfen von Al, aus $Al_2O_3$ für das Aufdampfen von Ag usw. auszurüsten, damit nicht mehr die eigentlichen Tiegel, sondern das sich in den Tiegeln befindliche Aufdampfgut von der Last- oder Arbeitsspule, d. h. von der die erwünschten Wirbelströme erzeugenden Spule des Induktions-Heizgenerators erwärmt wird. Doch leidet auch diese Tiegelart an verschiedenen Nachteilen, insbesondere an der durch die hohe Temperatur bedingten kurzen Standzeit, da die Temperatur vom geschmolzenen Aufdampfgut durch Kontakt unmittelbar übertragen wird. Dasselbe gilt auch für die sogenannten Rinnenschmelzöfen, in englischer Sprache auch als »submerged resistor furnace« bezeichnet, die sich zwar gut zum induktiven Schmelzen, nicht aber für das eine viel höhere Temperatur verlangende Aufdampfen eignen.

Die derzeit zum Aufdampfen verwendeten Verdampfer haben außer der kurzen Standzeit noch den Nachteil, daß auch solche Teile des Verdampfers, die nicht am eigentlichen Aufdampfen beteiligt sind, beispielsweise die Seitenflächen und der untere Teil eines widerstandsbeheizten Verdampfers und auch die unbenetzte Innenseite und der obere Rand eines induktionsbeheizten Tiegels, eine der hohen Aufdampftemperatur entsprechende, unerwünschte thermische Strahlung erzeugen, welche aufgrund des meistens hohen thermischen Strahlungskoeffizienten des Stoffes, aus welchem der Verdampfer hergestellt ist, besonders störend wirkt. Demzufolge ist man gezwungen, die Verdampfer in einem Abstand von über 100 mm unterhalb des zu bedampfenden Objektes zu unterbringen, damit wärmeempfindliche Güter, wie beispielsweise Kunststoffolien, lackierte Papierbahnen usw. durch die Strahlungswärme nicht beschädigt werden.

Eine so große Entfernung bringt aber auch eine nur schlechte, meistens um 30% liegende Ausbeute des Aufdampfgutes mit sich. Auch werden durch die großen Abstände zwischen zu bedampfendem Gut und Verdampferoberfläche erhöhte Anforderungen an die Hochvakuumpumpen gestellt, denn die mittlere, freie Weglänge der Restgase muß bekanntlich den Abstand des Verdampfers zu dem zu bedampfenden Objekt stets übertreffen.

Die schlechte Ausbeute des Aufdampfgutes verursacht auch ein übermäßiges Verschmutzen der Anlage, die deshalb nur zu oft einer zeitraubenden Reinigung unterworfen werden muß.

Hohe Standzeiten und eine geringe, allein vom geschmolzenen Aufdampfgut ausgehende Wärmestrahlung könnte man hingegen erzielen, wenn man das bekannte Schwebeverfahren

**0 024 604**

anwendet. In diesem Verfahren, erstmals in der DE-PS 422 044 von O. Muck vorgeschlagen, wird ein elektrisch leitender Stoff im festen oder flüssigen Zustand durch elektromagnetische Kräfte in der Schwebe gehalten und kann gleichzeitig zum Verdampfen gebracht werden. Doch kondensiert ein beträchtlicher Teil des Dampfes auf der den Schwebezustand hervorrufenden Arbeitsspule (Induktionsspule), welche deshalb in verhältnismäßig kurzen Abständen gereinigt werden muß. So berichtet beispielsweise J. Van Audenhove in seinem Artikel: »Vacuum Evaporation of Metals by High Frequency Levitation Heating«, Review of Sci. Instr., Vol. 36, March 1965, 383—385, daß rund 50% des jeweils verdampften Metalles auf die wassergekühlte Arbeitsspule aufkondensiert war und von dieser erst nach Luftzulaß entfernt werden konnte. Es ist klar, daß ein solches Aufkondensieren, falls es nicht rechtzeitig behoben wird, keinen viele Stunden dauernden Betrieb gestattet.

Aufgabe der Erfindung ist es, eine Vorrichtung zum Bedampfen von bewegten oder unbewegten Gegenständen, wie Trägerfolien im Hochvakuum mit einem leitenden Material (Metall oder Halbleiter), wobei die Verdampfungshitze durch induktive Erhitzung im zu verdampfenden Gut selbst erzeugt und das zu verdampfende Material im Magnetfeld der zur induktiven Erhitzung vorgesehenen Induktionsspule in Schwebe gehalten wird, anzugeben, bei der ein Niederschlag des Aufdampfgutes auf Spulenteilen vermieden wird, um damit den Einsatz der induktiven Erhitzung bei Anwendung des Schwebeverfahrens für Bedampfungsanlagen wirtschaftlich zu ermöglichen.

Diese Aufgabe wird mit einer Vorrichtung mit den Merkmalen des Patentanspruches 1 gelöst.

Erfindungsgemäß werden vor den dem Verdampfungsgut ausgesetzten Teilen der Induktionsspule elektrisch und thermisch von diesen getrennte Schutzkörper aus einem elektrisch nicht leitenden Material vorgesehen.

Das sich auf diesen Schutzkörpern niederschlagende Verdampfungsgut bleibt dabei dem induktiven Feld der Hochfrequenzenspule ausgesetzt und verdampft aufgrund des in ihm erzeugten Stromflusses aufs Neue und wird dabei in die schwebende Schmelze zurückgeführt.

Auf diese Weise wird erreicht, daß die Teile, die der Gefahr eines Niederschlages des Aufdampfgutes ausgesetzt sind, und das dort im Laufe der Zeit eine immer stärkere Schicht hervorrufen könnte, von dem Aufdampfgut weitgehend freigehalten werden.

Die Erfindung bezieht sich auch auf ein Verfahren zum Bedampfen von bewegten oder unbewegten Gegenständen, wie Trägerfolien oder dgl. im Hochvakuum mit einem leitenden Material (Metall oder Halbleiter), wobei die Verdampfungshitze durch induktive Erhitzung im zu verdampfenden Gut selbst erzeugt und das zu verdampfende Material im Magnetfeld der zur induktiven Erhitzung vorgesehenen Induktionsspule in Schwebe gehalten wird, dadurch gekennzeichnet, daß vor den dem Verdampfungsgut ausgesetzten Teilen der Induktionsspule (L) elektrisch und thermisch von diesen getrennte Schutzkörper (T) vorgesehen sind, die so angeordnet sind, daß die sich auf den Schutzkörper gegebenenfalls niederschlagenden Schichten oder Tropfen des Aufdampfgutes dem Hochfrequenzfeld der Spule ausgesetzt bleiben, und daß der Schmelze des zu verdampfenden Materials ein leitendes Material, beispielsweise Wolfram, mit einem geringeren Dampfdruck als das zu verdampfende Material zugefügt ist.

Bei der Vorrichtung nach der Erfindung kann auch die lästige Wärmestrahlung durch Abschirmen der am Aufdampfen nicht beteiligen Verdampferteile so weit vermindert werden, daß die Verdampfungseinrichtung in unmittelbarer Nähe der zu verdampfenden Folien, z. B. wärmeempfindlichen Kunststoffolien angebracht werden kann. Dadurch wird die Ausbeute des Aufdampfgutes bedeutend erhöht sowie der produktionshemmende, zur Reinigung der Anlage benötigte Zeitaufwand entsprechend vermindert. Diese Maßnahme gestattet es auch, bei unverminderter Aufdampftemperatur die Bandgeschwindigkeit einer Bandbedampfungsanlage entsprechend zu erhöhen bzw. bei unveränderter Geschwindigkeit die Temperatur des schwebenden Aufdampfgutes entsprechend zu vermindern, damit auch besonders wärmeempfindliche oder stark entgasende Bedampfungsobjekte bedampft werden können. Der verkürzte Abstand zwischen Verdampfer und Bedampfungsgut wirkt sich nicht zuletzt auch vorteilhaft auf Planung und Bau der Anlage aus; in den meisten Fällen kann auf die aufwendigen Diffusionspumpen verzichtet werden, denn der verkürzte Abstand erübrigt die bisher benötigten großen, freien Weglängen der Restgase. Den neuen Anforderungen genügen bereits handelsübliche Dampfstrahlpumpen.

Nicht zuletzt sei auch auf die Vorteile hingewiesen, die sich dadurch ergeben, daß ein geschmolzenes und schwebendes Aufdampfgut in den meisten Fällen nicht nur an seiner Oberseite, wie bei den derzeit verwendeten keramischen Verdampfern üblich, sondern auch an der nicht aufdampfenden Unterseite mit einem drahtförmigen Aufdampfgut, wie beispielsweise mit einem Aluminiumdraht, »gefüttert« werden kann. Dadurch wird nicht nur ein lästiges Bedampfen der Drahtzufuhrvorrichtung vermieden, sondern es werden auch jene sogenannten »Spritzer« vermieden, die die bekannten Gaseinschlüsse beim Anschmelzen des Drahtes verursachen, denn das Anschmelzen erfolgt weit unterhalb der aufdampfenden Oberfläche. Solche »Spritzer« erzeugen bekanntlich nicht nur unerwünschte Punkte in der Aufdampfschicht, sondern durchstoßen auch oft den dielektrischen Träger oder bleiben in diesem stecken, was zu qualitativer, durch die Erfindung vermeidbarer Beeinträchtigung verschiedener Folien: metallisierter Folien für Textilfaser, für elektrostatische Kondensatoren, für optische Anwendungen usw. führt.

Für Planung und Herstellung moderner Bandbedampfungsanlagen, insbesondere air-to-air-Anla-

3

gen, ist außerdem der weitere Vorteil von besonderer Bedeutung, daß auch bei unvorhergesehenen Pannen wie Stromausfall, Lufteinbruch usw. die Betriebssicherheit bei den meisten in der Folge schematisch beschriebenen neuen Verdampfereinrichtungen wesentlich verbessert ist. Während die konventionellen Verdampfer wegen der bekannten Oxydationsgefahr allgemein mehrere Minuten Abkühlzeit vor Lufteinlaß benötigen und vorher noch die jeweils vorhandene Vertiefung zum Vermeiden gefährlicher thermischer Spannungen durch Verdampfen entleert werden muß, werden weder die neuen Verdampfer noch das Aufdampfgut bei einer Panne wie Stromausfall usw. beschädigt, denn bei jeder Stromunterbrechung fällt das schwebende Aufdampfgut augenblicklich auf die wassergekühlte Arbeitsspule oder auf ihren ebenfalls gekühlten Konzentrator, während die zum Abstoßen oder Verflüssigen der auftreffenden Dampfmoleküle eingesetzten Bestandteile der neuen Verdampfer mit keiner starken, gefährliche thermische Spannung hervorrufenden Schicht des Aufdampfgutes überzogen sind und ihre Temperatur erheblich unterhalb derjenigen des heißen Aufdampfgutes liegt.

Die folgenden Beispiele zeigen schematisch, wie mit ein- und derselben Arbeitsspule das Aufdampfgut zum gleichzeitigen Schweben und Verdampfen gebracht werden kann unter gleichzeitiger Verhinderung eines (dauerhaften) Aufkondensierens der verdampften Moleküle auf Teilen der Induktionsspule.

Zum besseren Verständnis der Beschreibung werden zunächst die induktive Erwärmung betreffenden Gleichungen, wie sie dem von der Firma VALVO veröffentlichten Buch »Hochfrequenz-Industrie-Generatoren«, Ausgabe Oktober 1975, Verlag Boysen & Maasch, 2000 Hamburg 1, Hermannstr. 31 zu entnehmen sind, angeführt:

In diesen Gleichungen bedeuten:

A = Querschnittsfläche der Lastspule (Induktionsspule) in $cm^2$
$A_L$ = Querschnittsfläche der zu erhitzenden Last in $cm^2$
D = Durchmesser der Lastspule in cm
d = Durchmesser der Last in cm
$\delta$ = Eindringtiefe in cm (berechnet für die jeweilige Höchsttemperatur, die die Last erreichen soll)
$\eta L$ = Lastspulenwirkungsgrad
f = Arbeitsfrequenz in Hz
I = Lastspulenstrom in A
L = Länge der Lastspule in cm
l = Länge der Last in cm
m = Masse der Last (des Lastwerkstoffes) in g
$\mu$ = Permeabilität der Last
n = Zahl der Windungen der Lastspule
n' = Zahl der Windungen der Lastspule pro cm Spulenlänge
$P_W$ = benötigte Leistung in kW
$\varrho_1$ = effektiver spezifischer Widerstand der Last in microohm cm
$\varrho_2$ = effektiver spezifischer Widerstand des Lastspulenmaterials in microohm cm
S = spezifische Wärme der Last in J/g K
t = die zum Aufheizen erforderliche Zeit (zuzüglich etwa 30% für Verluste) in s
$\vartheta_1$ = Ausgangstemperatur der Last in °C
$\vartheta_2$ = die zu erreichende Temperatur der Last in °C
U/n = Spannung pro Lastspulenwindung in V

$$\delta = 5,03 \sqrt{\frac{\varrho_1}{\mu f}} \, , \tag{1}$$

$$f_{min} = 16 \cdot 10^2 \frac{\varrho_1}{\mu d^2} \text{ (oder: } d_{min} = \delta \cdot 8 \text{)} \, , \tag{2}$$

$$\text{optimale Kopplung} = \frac{L}{D} = \frac{l}{d} = 1,5 \, , \tag{3}$$

$$P_W = \frac{(\vartheta_2 - \vartheta_1) \, m \, S}{1000 \cdot t} \, , \tag{4}$$

$$\eta_L = \frac{1}{1 + \dfrac{D^2}{d^2} \left(1 + 6,25 \dfrac{\delta^2}{d^2}\right) \sqrt{\dfrac{\varrho_2}{\mu \cdot \varrho_1}}} \, , \tag{5}$$

$$n\,I_{rms} = \sqrt{\frac{P_W \delta l \, 10^9}{\pi \varrho_1 d}} \, , \tag{6}$$

4

$$\frac{U}{n} = 0.08 \, n' \, f l \, (A - A_L) \, 10^{-6} . \tag{7}$$

Die im folgenden erläuterten Beispiele nehmen auf die Zeichnung bezug, in welcher verschiedene Ausführungsformen von Induktionsverdampfern für Aufdampfvorrichtungen schematisch und ausschnittweise wiedergegeben sind.

Dabei zeigt

Fig. 1 einen Längsschnitt durch eine induktionserhitzte Schmelzvorrichtung mit schwebendem Schmelzgut gemäß dem Stand der Technik,

Fig. 2 eine Ausführungsform einer Vorrichtung gemäß der Erfindung mit Schutzkörper in Form einer Abschirmung vor Spulenabschnitten,

Fig. 3 eine weitere Ausführungsform mit allseits abgeschirmten Spulenabschnitten,

Fig. 4 eine Ausführungsform mit in der Schmelze angeordneter Induktionsspule nach Art eines Rinnenschmelzofens im Längsschnitt,

Fig. 5 einen Querschnitt durch eine Weiterbildung einer Ausführungsform nach Fig. 4, wobei die untere Rinne des Schmelzgutes durch einen aus Kupfer hergestellten Bügel ersetzt ist und

Fig. 6 eine Verdampfungseinrichtung mit einer Induktionsspule mit vertikaler Achse.

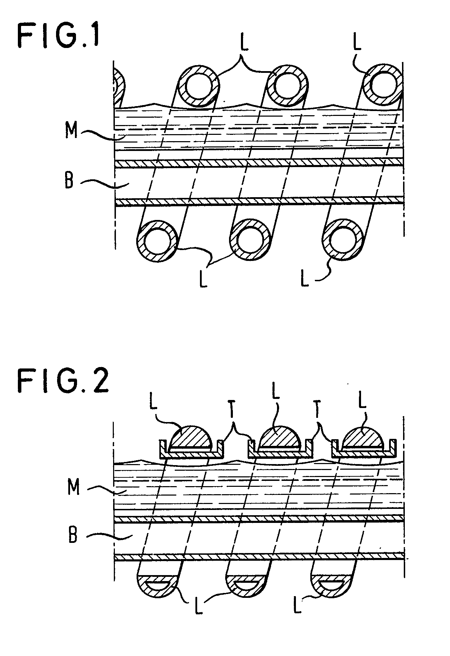

Im einzelnen ist in Fig. 1 im Längsschnitt eine induktionserwärmte Schmelzvorrichtung mit schwebendem Schmelzgut gezeigt, wie sie im DE-PS 518 499 (2. 11. 26) zum Schmelzen von hochschmelzenden Metallen, wie Ta, Th, W oder Legierungen dieser Metalle vorgeschlagen wurde und noch heute mit Erfolg zum Schmelzen, insbesondere auch zu dem bekanntlich hohe Anforderungen stellenden Zonenschmelzen verwendet wird. Das metallische Schmelzgut M schwebt in einem horizontal angeordneten, wassergekühlten Boot B, welches aus einem einzigen Stück oder auch aus einzelnen Segmenten bestehen kann. Das Boot B ist dabei im allgemeinen aus Kupfer gefertigt, wobei es gleichzeitig als Konzentrator (Stromverstärker) für die meistens aus mehreren Windungen bestehende Lastspule L wirkt. Laut Angaben in der vorgenannten Patentschrift kann das Boot aber auch durch ein Quarzrohr oder dgl. ersetzt werden.

Aufgrund der im Schmelzgut M und in dem Boot B erzeugten, induzierten Ströme entstehen entgegengerichtete Felder, die ein Abheben des Schmelzgutes von der Oberfläche des Bootes B zur Folge haben, und zwar gleichgültig, bis zu welcher Temperatur das Schmelzgut aufgeheizt wird.

Erfahrungsgemäß setzen sich die Hauptverluste einer derartigen, mit einem gut polierten Kupferboot ausgerüsteten und hochfrequenztechnisch richtig konstruierten Schmelzanlage aus den durch Wärmestrahlung und Abdampfwärme der offenen, d. h. nicht von dem Kupfer des Bootes abgedeckten Oberfläche der schwebenden Schmelze erzeugten Verluste zusammen. Die kalorimetrisch leicht erfaßbaren Verluste im wassergekühlten Kupferboot betragen nur einen Bruchteil der eingekoppelten Hochfrequenzenergie.

Eine derartige Vorrichtung ermöglicht zwar ein Aufheizen des Schmelzgutes M auf Verdampfungstemperatur. Die Vorrichtung selbst ist jedoch zum Aufdampfen nicht geeignet, da die Dämpfe auf dem oberen Teil der wassergekühlten Induktionsspule L aufkondensieren und, da sie dort abgekühlt werden und aus leitendem Material sind, zu Kurzschlüssen, Funkenbildung und schließlich zur totalen Abschirmung zwischen Oberseite des Schmelzgutes und den oberhalb der Spule geführten, zu bedampfenden Folien führen.

Die Anwendung der Merkmale der Erfindung ermöglicht nun den Einsatz einer derartigen Schmelzvorrichtung auch für die Zwecke des Aufdampfens dadurch, daß dafür gesorgt ist, daß das Aufdampfgut von den Spulenteilen weggehalten und beim Auftreffen auf die Schutzkörper nach einem Aufkondensieren in flüssigem Zustand gehalten, erneut verdampft und vorzugsweise in das schwebende Aufdampfgut zurückgeführt werden.

Eine hierfür geeignete Ausführungsform einer Vorrichtung nach der Erfindung zeigt die Fig. 2. Die dort in einem Ausschnitt der Länge nach geschnittene Verdampfungseinrichtung ist analog zu der Erhitzungseinrichtung nach Fig. 1 aufgebaut. Die identischen Teile sind mit entsprechenden Bezugszeichen versehen. Im Ausführungsbeispiel nach Fig. 2, besteht die Induktionsspule in ihrer Gänze aus einem elektrisch gut leitenden Metall wie Kupfer. Die dem Dampf ausgesetzten Teile der Spule sind geschützt, damit das Aufdampfgut nicht auf Spulenteile aufkondensieren kann.

Die aus einem wassergekühlten Kupferrohr bestehende und mit einem (nicht gezeigten) temperaturbeständigen, elektrisch isolierenden Überzug wie Silikonlack usw. versehene Lastspule wird hierzu durch Schutzplättchen oder aufgebördelte Schutzstreifen T, die zwischen dem schwebenden Aufdampfgut M und den oberen Windungsabschnitten der Induktionsspule L untergebracht sind, vor einem dauerhaften Aufkondensieren der vom Aufdampfgut M ausgehenden Dämpfe geschützt.

Für eine günstige Einstellung eines Strahlungsabsorptionskoeffizienten kann ein weißes anorganisches Dielektrikum, wie beispielsweise BN, mit einem grauen Dielektrikum, wie beispielsweise AIN gemischt und zur Herstellung der Plättchen oder Streifen T gesintert werden. Es kann auch ein streifenförmiges Plättchen T aus einem elektrisch nicht leitenden, temperaturfesten Dielektrikum, wie beispielsweise BN oder $Al_2O_3$ hergestellt und quer über das Kupferboot B gelegt werden, damit die aufkondensierten Dämpfe selbst hochschmelzender Metalle einen Kurzschlußwindungsteil bilden und durch den induzierten Strom abschmelzen.

Auch sieht die Erfindung vor, anstelle von Streifen oder Plättchen anders geformte, ein dauerhaftes Aufkondensieren verhindernde Abschirmungen, wie beispielsweise die oberen Lastspulenteile ganz oder teilweise umhüllende Hülsen usw. zu verwenden. Weiterhin können die oberen Lastspulenteile aus massivem, allein an den beiden Enden gekühltem Kupfer bestehen, damit sie leicht ausgewechselt bzw. die Schutzhülsen leicht ersetzt werden können. Damit die Wärmeübertragung der zur Abschirmung vorgesehenen Streifen usw. auf die Induktionsspule auf ein Mindestmaß reduziert wird, sieht die Erfindung ein thermisch isoliertes bzw. die Lastspule nicht oder kaum kontaktierendes Anbringen der ersteren vor.

Gemäß einer bevorzugten Ausführungsmöglichkeit kann die Induktionsspule, welche an sich jede Form annehmen kann, als Torus eingesetzt werden, damit andere, in der Vakuumanlage untergebrachte, metallische Objekte nicht als unerwünschte Lasten in den Erwärmungsprozeß miteinbezogen werden.

Vorzugsweise ist die Induktionsspule auf der Unterseite durch eine einzige, breite Verbindung gebildet, welche im oberen, dem Schmelztiegel überspannenden Bereich in eine Mehrzahl elektrisch parallel geschalteter Windungen aufgeteilt ist.

Weiterhin kann die Vorrichtung auch zum Aufdampfen von oben nach unten oder in senkrechter Richtung erfolgen, denn das verdampfte und auf den Schutzplättchen in Tröpfchen- oder Dünnschichtenform kondensierte Aufdampfgut wird von den das Schweben verursachenden Kräften in das schwebende Schmelzgut-Aufdampfgut zurückgeführt.

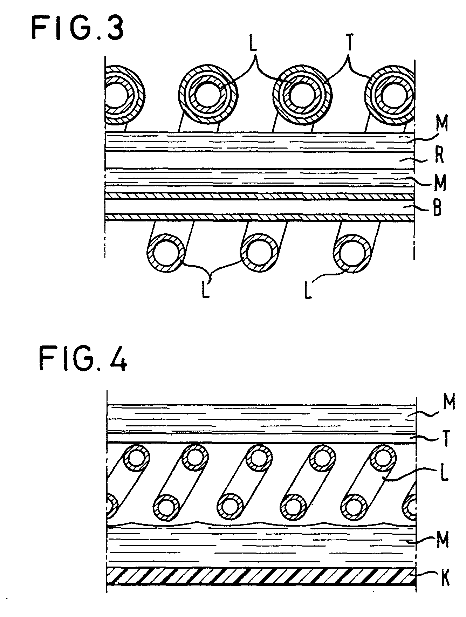

Die Fig. 3 zeigt, daß es im Rahmen der Erfindung auch möglich ist, im Gegensatz zu den bevorstehend beschriebenen Beispielen dem schwebenden Aufdampfgut auch eine Hohlkörperform zu geben, damit die in Gleichung (4) erscheinende Aufheizzeit t verkürzt und die bei einem gegebenen spezifischen Gewicht und Eindringtiefe $\delta$ erforderlichen Mindestmaße herabgesetzt werden können, ohne die Leistung $P_W$ zu verändern. Eine schematische Darstellung dieser Ausführungsform ist in Fig. 3 im Längsschnitt schematisch gezeigt. Das schwebende, von der Induktionsspule L erwärmte und gleichzeitig abgestoßene Aufdampfgut M umschließt den runden Fremdkörper R, der in verschiedenen Ausführungsformen eingesetzt werden kann. So kann er beispielsweise aus einer von einem Gegenstrom durchströmten Spule, welche das schwebende Aufdampfgut ebenfalls abstößt oder aus einem keramischen, dem schwebenden Aufdampfgut gegenüber korrosionsfesten Material hergestellten Körper bestehen. In letzterem Falle ist diese Ausführungsform einem invertierten Rinnenschmelzofen ähnlich, bei welchem aber die äußere Rinnenwand von der bekannten, durch die Badbewegung bedingten Erosion verschont bleibt, da das Aufdampfgut von der Lastspule abgestoßen und in den Schwebezustand versetzt wird.

In den vorangehenden Beispielen war stets ein Teil der Induktionslastspule zwischen dem schwebenden Aufdampfgut und den zu bedampfenden Gegenständen angeordnet und es wurde beschrieben, wie das dauernde Aufkondensieren des Dampfes auf diesen das schwebende Aufdampfgut einschließenden oder umhüllenden Teilen der Lastspule verhindert werden soll. Die folgenden Beispiele beschreiben hingegen Ausführungsformen, bei welchen der Zwischenraum zwischen dem schwebenden Aufdampfgut und den zu bedampfenden Gegenständen frei bleibt, wobei aber die Lastspule, d. h. die die elektromagnetische Hebekraft erzeugende Induktionsspule dennoch vor einem dauerhaften Aufkondensieren des Dampfes geschützt werden muß.

Die Fig. 4 zeigt im Längsschnitt einen Aufbau der einem konventionellen Rinnenschmelzofen entspricht, der je nach der verwendeten Arbeitsfrequenz mit oder ohne Magnetkern eingesetzt wird. Während aber in der üblichen Ausführungsform solcher Öfen der obere Teil des Ofens den größeren Rinnenquerschnitt besitzt und das eigentliche Erwärmen des Schmelzgutes im unteren Teil der Rinne erfolgt, ist in der neuen Ausführungsform die Rinne oben und nicht unten eingeengt, so daß das Schmelzgut im oberen Teil auf die eigentliche Aufdampftemperatur erwärmt und gleichzeitig durch die Lastspule L von dieser abgehoben wird, während der Rest des Schmelzgutes infolge des größeren Rinnenquerschnittes die Aufdampftemperatur nicht erreicht und deshalb den keramischen Behälter K, gegen welchen das Schmelzgut von der Lastspule L abgestoßen wird, nicht so stark korrodiert, als das bei einer der Aufdampftemperatur entsprechenden Temperatur der Fall wäre. Somit kann das Aufdampfgut nach oben hin frei verdampfen, während die in Richtung der Lastspule abdampfenden Dämpfe dort verständlicherweise wieder verflüssigt und in das schwebende Aufdampfgut zurückfließen. Damit die durch das flüssige und zum Teil schwebende Aufdampfgut M gebildete Kurzschluß-Sekundärwicklung der Lastspule L auch bei Unterbrechung des oberen Stromweges unter Strom bleibt, ist der obere Teil der Lastspule L gegenüber dem Schmelzgut mit einer Platte T aus einem elektrisch nicht leitenden Material thermisch und elektrisch isoliert. Dadurch wird ein Kurzschließen der sich nach oben abhebenden Teile der Windung vermieden.

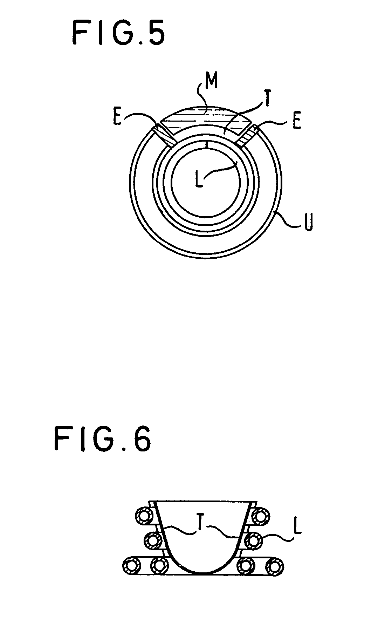

Die Fig. 5 zeigt im Querschnitt eine vereinfachte, energiesparende Ausführung des im letzten Beispiel beschriebenen Verdampfers, dessen untere Rinne durch einen aus Kupfer hergestellten und wassergekühlten Bügel U ersetzt ist, der das schwebende Aufdampfgut M als Teil der Kurzschlußwindung mit Strom versieht. Damit aber das Kupfer nicht von dem schwebenden Aufdampfgut korrodiert wird, wird auf den beiden Enden des Bügels U je eine dem geschmolzenen Aufdampfgut gegenüber korrosionsfeste, elektrisch leitende Elektrode E befestigt, welche wiederum durch eine elektrisch nicht leitende Platte T verbunden ist. Dadurch, daß die Elektroden E fest mit dem wassergekühlten Kupferbügel U verbunden sind, bleibt ihre Temperatur unterhalb der Temperatur des schwebenden Aufdampfgutes, welches insbesondere in der Mitte zwischen den beiden Elektroden Temperaturen aufweist, die etliche 100°C oberhalb der mittleren Temperatur der Elektroden liegen kann. Die nach unten abdampfenden Dämpfe werden auch hier verflüssigt und in das schwebende Aufdampfgut zurückgeführt. Die Drahtzuführung kann wie bei den konventionellen, widerstandsbeheizten Verdampfern erfogen.

Die Fig. 6 schließlich zeigt, wie eine aus der Technologie des Schwebeschmelzverfahrens wohl bekannte Lastspule mit vertikaler Achse so ergänzt oder verbessert werden kann, daß sie zum laufenden Aufdampfen geeignet wird, ohne daß das lästige dauerhafte Aufkondensieren der Dämpfe an der Lastspule auftritt. Hierzu ist gemäß einer anderen Weiterbildung des Erfindungsgedankens die Innenseite der im Querschnitt gezeigten Lastspule L mit einem zusammenhängenden, dem geschmolzenen Aufdampfgut gegenüber korrosionsfesten, elektrisch isolierenden Überzug T versehen. Sobald die aufkondensierten Dämpfe eine Kurzschlußwindung bilden, wird diese vom Strom durchflossen und schmilzt und wird in das schwebende Aufdampfgut zurückgeführt. Damit die Strahlungswärme des schwebenden Aufdampfgutes bei dem Anschmelzen der aufkondensierten Kurzschlußwindungen nicht unbenützt bleibt, wird die Lastspule L vorzugsweise mit einem elektrisch und thermisch isolierenden Überzug versehen und erst dieser, der beispielsweise aus Mineralfaser bestehen kann und demzufolge den Überzug T auch besser verankert, mit einer den Überzug T ergebenden Suspension oder Paste bestrichen. Auch bei dieser Lastspulenform kann die Drahtzuführung von der Kehrseite her erfolgen.

Die oben angeführten Beispiele dienen lediglich zur Demonstration verschiedener Ausführungsformen der Erfindung, wobei eine Reihe anderer Realisierungsmöglichkeiten gegeben sind. Gemäß der Erfindung ist lediglich darauf zu achten, daß Maßnahmen getroffen sind, die es gestatten, den aus einem schwebenden Aufdampfgut auf die das Schweben hervorrufende Spule des Verdampfers aufkondensierende Dampfmoleküle ohne mechanische Reinigung laufend zu entfernen und vorzugsweise in das schwebende Aufdampfgut zurückzuführen oder sofort wieder abzudampfen. Auf diese Weise werden die Standzeiten dieser derzeit zum Herstellen konventioneller Verdampfer verwendeten Stoffe vervielfacht und somit Aufdampfvorrichtungen mit langer Standzeit, verbunden mit anderen beschriebenen Vorteilen, geschaffen.

## Patentansprüche

1. Vorrichtung zum Bedampfen von bewegten oder unbewegten Gegenständen, wie Trägerfolien im Hochvakuum mit einem leitenden Material (Metall oder Halbleiter), wobei die Verdampfungshitze durch induktive Erhitzung im zu verdampfenden Gut selbst erzeugt und das zu verdampfende Material im Magnetfeld der zur induktiven Erhitzung vorgesehenen Induktionsspule in Schwebe gehalten wird, dadurch gekennzeichnet, daß vor den dem Verdampfungsgut ausgesetzten Teilen der Induktionsspule (L) elektrisch und thermisch von diesen getrennte Schutzkörper (T) aus einem elektrisch nichtleitenden Material vorgesehen sind, die so angeordnet sind, daß die sich auf den Schutzkörper ggf. niederschlagenden Schichten oder Tropfen des Aufdampfgutes dem Hochfrequenzfeld der Spule ausgesetzt bleiben.

2. Vorrichtung nach Anspruch 1, dadurch gekennzeichnet, daß als Schutzkörper (T) streifenförmige Abschirm-Plättchen aus einem, temperaturfesten Material, beispielsweise BN oder $Al_2O_3$, vorgesehen sind.

3. Vorrichtung nach Anspruch 1 und 2, dadurch gekennzeichnet, daß die die zu schützenden Abschnitte der Induktionsspule umgebenden Abschirmungen von diesen getrennt sind.

4. Vorrichtung nach Anspruch 1, dadurch gekennzeichnet, daß die zu schützenden, vorzugsweise aus wassergekühlten Kupferrohren bestehenden Spulenabschnitte mit einem temperaturbeständigen, elektrisch isolierenden Überzug, wie Silikonlack versehen sind, auf welchen die Schutzkörper (T) angeordnet sind.

5. Vorrichtung nach Anspruch 1, dadurch gekennzeichnet, daß das Aufdampfgut (M) unter Verwendung eines Fremdkörpers (R) in Hohlkörperform in der Spule gehalten ist.

6. Vorrichtung nach einem der Ansprüche 1 bis 5, dadurch gekennzeichnet, daß eine Schmelzrinne (Schmelzboot) zur räumlichen Fixierung des zu schmelzenden Materials innerhalb der Induktionsspule vorgesehen ist, auf dessen Ränder streifenförmige Schutzkörper gelegt sind, so daß aufkondensierendes Material selbst eine Kurzschlußwindung bildet, wodurch dieses durch Stromfluß auf die gewünschte Abschmelztemperatur gebracht wird.

7. Vorrichtung nach einem der vorhergehenden Ansprüche, dadurch gekennzeichnet, daß die Induktionsspule auf der Unterseite durch eine einzige, breite Windung gebildet ist, welche im oberen, dem Schmelztiegel überspannenden Bereich in eine Mehrzahl elektrisch parallel geschalteter Windungen aufgeteilt ist.

8. Vorrichtung nach Anspruch 7, dadurch gekennzeichnet, daß der untere Teil der Induktionsspule selbst als Boot, Tiegel oder Rinne ausgebildet ist.

9. Vorrichtung nach einem der Ansprüche 4 bis 6 mit einer Induktionsspule mit senkrechter Achse, dadurch gekennzeichnet, daß der Schutzkörper (T) für die Induktionsspule (L) tiegelförmig ausgebildet ist.

10. Verfahren zum Bedampfen von bewegten oder unbewegten Gegenständen, wie Trägerfolien oder dgl. im Hochvakuum mit einem leitenden Material (Metall oder Halbleiter), wobei die Verdampfungshitze durch induktive Erhitzung im zu verdampfenden Gut selbst erzeugt und das zu verdampfende Material im Magnetfeld der zur induktiven Erhitzung vorgesehenen Induktionsspule in Schwebe gehalten wird, dadurch gekennzeichnet, daß vor den dem Verdampfungsgut ausgesetzten Teilen der Induktionsspule (L) elektrisch und thermisch von diesen getrennte Schutzkörper (T) vorgesehen sind, die so angeordnet sind, daß die sich auf den Schutzkörper gegebenenfalls niederschlagenden Schichten oder Tropfen des Aufdampfgutes dem Hochfrequenzfeld der Spule ausgesetzt bleiben und daß der Schmelze des zu verdampfenden Materials ein leitendes Material, beispielsweise Wolfram, mit einem geringeren Dampfdruck als das zu verdampfende Material, zugefügt ist.

## Claims

1. Apparatus for vapour coating in high vacuum moving and stationary targets such as webs with an electrically conductive substance (metal or semi-conductor) wherein the heat required für evaporation is produced by directly heating said evaporand by means of an induction heating coil the magnetic field of which provides for the levitation of said evaporand, characterized in that screens or shields (T) made of an electrically non conducting material and electrically as well as thermally insulated from parts of the induction heating coil (L) exposed to the evaporand, are placed before said coil parts in such a way that coatings or drops of the evaporand that may condense on said screens or shields, remain exposed to the high frequency field of the coil.

2. Apparatus according to claim 1, characterized in that stripe-shaped screens or shields (T) made of a temperature resistant material such as BN or $Al_2O_3$ are being provided.

3. Apparatus according to claims 1 and 2, characterized in that the screens or shields surrounding those parts of the induction heating coil that have to be protected, are kept separated from the latter.

4. Apparatus according to claim 1, characterized in that the coil parts to be protected, preferentially made of watercooled copper tubing, are coated with a temperature resistant, electrically insulating coating such as silicone varnish on which the screens or shields (T) are being mounted.

5. Apparatus according to claim 1, characterized in that a foreign body (R) is being used for keeping the evaporand (M) in a hollow-shaped form within the induction heating coil.

6. Apparatus according to claims 1 to 5, characterized in that a boat-shaped crucible is provided for positioning the material to be melted within the induction heating coil, with stripe-shaped screens or shields laid across said boat so that material condensed on said screens forms part of a short-circuited winding the current flow in which causes the temperature to rise to the temperature required for melting off the condensate.

7. Apparatus according to one of the preceding claims, characterized in that the lower part of the induction heating coil is made of a single broad winding, whereas the upper part stretching over the crucible is made of several electrically parallel windings.

8. Apparatus according to claim 7, characterized in that the lower part of the induction coil itself is shaped as a channel, boat, or round crucible.

9. Apparatus according to one of the claims 4 to 6 comprising an induction heating coil with a vertical axis, characterized in that the screen or shield (T) of the induction heating coil (L) has the shape of a crucible.

10. A method of vapour coating in high vacuum moving and stationary targets such as webs with an electrically conductive substance (metal or semi-conductor) wherein the heat required for evaporation is produced by directly heating said evaporand by means of an induction heating coil the magnetic field of which provides for the levitation of said evaporand, characterized in that screens or shields (T) made of an electrically non conducting material and electrically as well as thermally insulated from parts of the induction heating coil (L) exposed to the evaporand, are placed before said coil parts in such a way that coatings or droplets of the evaporand condensed on said screens or shields remain exposed to the high frequency field of the coil, and that a conducting material such as tungsten, having a lower vapour pressure than that of the evaporand, is added to the evaporand melt.

## Revendications

1. Dispositif destiné à l'évaporation sous vide de substances conductrices (métaux et semi-conducteurs) sur objets en mouvement ou immobiles, la chaleur nécessaire à l'évaporation étant produite dans les substances conductrices elles-mêmes par le chauffage dû à une bobine d'induction dont le champ électromagnétique maintient en lévitation les substances à évaporer, charactérisé en ce que des écrans ou caches (T) sont disposés devant les parties de la bobine d'induction (L) exposées à la substance que l'évapore, lesdits écrans ou caches, faits en matière ne conduisant pas le courant électrique, étant séparés électrique et thermique, et disposés de telle manière que les couches ou gouttes produites par une condensation éventuelle de la substance que l'on évapore sur lesdits écrans ou caches, restent exposées au champ haute fréquence de la bobine.

2. Dispositif selon la 1ère revendication, caractérisé en ce que les écrans ou caches (T) consistent en bandes faites en matière résistant à la chaleur, telle que par exemple le BN ou l'$Al_2O_3$.

3. Dispositif selon les revendications 1 et 2, caractérisé en ce que les écrans ou caches entourant les parties à protéger de la bobine d'induction sont séparés de ces dernières.

4. Dispositif selon la 1ère revendication, caractérisé en ce que les parties à protéger de la bobine, de préférence construites en tuyeaux de cuivre, portent un revêtement isolant électrique et thermique tel que le vernis silicone, et que ce revêtement port à son tour les écrans ou caches (T).

5. Dispositif selon la 1ère revendication, caractérisé en ce que la substance à évaporer (M) revèt à l'intérieur de la bobine une forme concave due à l'emploi d'un corps étranger (R).

6. Dispositif selon l'une des revendications 1 à 5, caractérisé en ce qu'un gouttière (nacelle) sert à la fixation dans l'espace de la substance destinée à être fondue à l'intérieur de la bobine d'induction, et que les bords de ladite gouttière portent des écrans ou caches en forme de bandes, de telle sorte que la substance condensée sur lesdites bandes forme une spire courtcircuitée faisant circuler un courant lequel porte la substance condensée à la température de fusion voulue.

7. Dispositif selon l'une des revendications précédentes, caractérisé en ce que la partie inférieure de la bobine est formée d'une seule spire large, et que sa partie supérieure, étendue au-dessus de la gouttière (nacelle), est divisée dans une pluralité de spires branchées en parallèle.

8. Dispositif selon la revendication précédente, caractérisé en ce que la partie inférieure de la bobine d'induction elle-même est façonnée en forme de nacelle, creuset, ou gouttière.

9. Dispositif selon l'une des revendications 4 à 6 comprenant une bobine d'induction à l'axe vertical, caractérisé en ce que l'écran ou cache (T) de la bobine d'induction (L) revèt la forme d'un creuset.

10. Un procédé d'évaporation sous vide poussé de substances conductrices (métaux et semi-conducteurs) sur objets en mouvement ou immobiles tels que supports en feuilles, la chaleur nécessaire à l'évaporation étant produite dans les substances elles-mêmes par l'effet chauffant d'une bobine d'induction dont le champ électromagnétique provoque la lévitation des substance à évaporer, caractérisé en ce que des écrans ou caches (T) sont disposés devant les parties de la bobine d'induction (L) exposées à la substance que l'on évapore, lesdits écrans ou caches, faits en matière ne conduisant pas le courant électrique, étant séparés desdites parties de la bobine par isolation électrique et thermique, et disposés de telle façon que les couches ou gouttes produites par une condensation éventuelle des vapeurs de la substance que l'on évapore sur lesdits écrans ou caches, restent exposées au champ haute fréquence de la bobine, et qu'une substance conductrice ayant une tension de vapeur plus faible que la substance que l'on désire évaporer, telle que par exemple du tungstène, est ajoutée à la substance que l'on désire évaporer.

# FIG.1

# FIG.2

# FIG.3

# FIG. 4

# FIG.5

# FIG.6